(19) Europäisches Patentamt
European Patent Office
Office européen des brevets

(11) EP 2 541 554 B1

(12) **EUROPEAN PATENT SPECIFICATION**

(45) Date of publication and mention of the grant of the patent:
**30.12.2015 Bulletin 2015/53**

(51) Int Cl.:
***G11C 11/14*** *(2006.01)*

(21) Application number: **11172214.6**

(22) Date of filing: **30.06.2011**

(54) **Magnetic functional device**

Funktionelle magnetische Vorrichtung

Dispositif fonctionnel magnétique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.01.2013 Bulletin 2013/01**

(73) Proprietor: **Hitachi, Ltd.**
**Chiyoda-ku**
**Tokyo (JP)**

(72) Inventors:
• **Wunderlich, Joerg**
  **Cambridge, Cambridgeshire CB3 0HE (GB)**
• **Roy, Pierre**
  **Cambridge, Cambridgeshire CB3 0HE (GB)**
• **De Ranieri, Elisa**
  **Cambridge, Cambridgeshire CB3 0HE (GB)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(56) References cited:
EP-A1- 2 015 307    US-A1- 2010 032 738
US-B1- 6 387 476    US-B2- 7 201 817

• WANG K Y ET AL: "Domain wall resistance in perpendicular (Ga,Mn)As: Dependence on pinning", JOURNAL OF MAGNETISM AND MAGNETIC MATERIALS, ELSEVIER SCIENCE PUBLISHERS, AMSTERDAM, NL, vol. 322, no. 21, 1 November 2010 (2010-11-01), pages 3481-3484, XP027197690, ISSN: 0304-8853 [retrieved on 2010-06-30]
• HAYASHI MASAMITSU ET AL: "Dynamics of domain wall depinning driven by a combination of direct and pulsed currents", APPLIED PHYSICS LETTERS, AIP, AMERICAN INSTITUTE OF PHYSICS, MELVILLE, NY, US, vol. 92, no. 16, 21 April 2008 (2008-04-21), pages 162503-162503, XP012106599, ISSN: 0003-6951, DOI: 10.1063/1.2903096
• JUNG SOON-WOOK ET AL: "Current-induced domain wall motion in a nanowire with perpendicular magnetic anisotropy", APPLIED PHYSICS LETTERS, AIP, AMERICAN INSTITUTE OF PHYSICS, MELVILLE, NY, US, vol. 92, no. 20, 22 May 2008 (2008-05-22), pages 202508-202508, XP012107154, ISSN: 0003-6951, DOI: 10.1063/1.2926664

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a magnetic functional device, such as a magnetic memory device or a magnetic logic device.

US 2010/0032738 A1 describes a magnetic tunnel junction cell having a free layer and first pinned layer with perpendicular anisotropy. The cell includes a coupling layer between the free layer and a second pinned layer, the coupling layer comprising a phase change material switchable from an antiferromagnetic state to a ferromagnetic state. At least one actuator electrode proximate the coupling layer transfers a strain from the electrode to the coupling layer to switch the coupling layer from the antiferromagnetic state to the ferromagnetic state.

K. Y. Wang et al.: "domain wall resistance in perpendicular (Ga,Mn)As: Dependence on pining", Journal of Magnetism and Magnetic Materials, volume322, pages 3481 to 3484 (2010) describes a Hall bar device comprising a layer of $Ga_{0.95}Mn_{0.05}As$. The Transport characteristics of the Hall bar device are measured. Domain walls are formed at an etching step and at one or more line defects using an external magnetic field. Firstly, a large positive (negative) magnetic field is applied perpendicular to the plane in order to align all of the magnetic domains in the device. Then, the field is swept to certain negative (positive) values, corresponding to the switching magnetic fields of the various magnetic domains, before reducing the external field to zero. PMOKM images of different magnetic configurations of the device, corresponding to one, two or three magnetic domain walls between Hall bar voltage probes.

US 6 483 741 B describes a magnetic functional device which includes an information carrier layer formed bya magnetic substance and a strain-imparting layer formed below the information layer and operably configured to impart a drive force to change the direction of a magnetization vector lying in a first plane of the information carrier. The drive force is applied in a pulse to the information carrier layer in a direction nearly perpendicular to the first plane in which lies the magnetization vector of the information carrier layer when the magnetization vector is in an initial state before the application of the drive force.

US 6.387 476 B describes a magnetic functional which includes a strain-sensitive magnetic layer having a magnetic state variable with strain and a strain applying layer adapted to apply strain to the strain-sensitive magnetic layer. The magnetic state of the strain-sensitive magnetic layer is controlled by controlling the strain applied to the strain-sensitive magnetic layer.

According to a first aspect of the present invention there is provided apparatus comprising a magnetic functional device comprising a layer of magnetostrictive material configured such that magnetic anisotropy is perpendicular to the layer, wherein the layer has a length and includes first and second domains divided, along the length, by a domain wall and means for imparting in-plane strain to the magnetostrictive layer, and a source configured to drive a current along the length of the magnetostrictive material layer so as to cause the domain wall to move along the length of the layer.

Thus, the strain imparting means can be used to induce a change of in-plane uniaxial anisotropy in the magnetostrictive layer. For example, this can be used to control the velocity of domain wall propagation in a magnetic racetrack-type device.

The strain may be tensile strain or compressive strain.

The strain imparting means may comprise a stressor, such as an actuator. The strain imparting means may comprise a piezoelectric element.

The layer may have a thickness no more than three times an exchange length of the magnetostrictive material. The layer may have a thickness, no more than 25 nm, no more than 10 nm or no more than 5 nm. The magnetostrictive layer may have a thickness of at least 1 nm, at least 1.5 nm, at least 2 nm or at least 3 nm.

The length of the magnetostrictive layer may be at least 200 nm, at least 500 nm, at least 1 μm, at least 10 μm or at least 100 μm.

The magnetostrictive layer may form a track. The track may have a width of at least 40 nm, at least 100 nm or at least 1 μm. The track may have a width of no more than 1 μm or no more than 5 μm.

The magnetostrictive layer may be elongate having a longitudinal axis and strain may be induced along the longitudinal axis.

The magnetostrictive material may comprise a ferromagnetic element, such as cobalt, iron or nickel. The magnetostrictive material may comprise an alloy of a ferromagnetic element and a non-ferromagnetic transition element, such as palladium or platinum. For example, the magnetostrictive material may comprise cobalt platinum.

The magnetic functional device may be a magnetic memory device and/or a magnetic logic device.

According to a second aspect of the present invention there is provided a method of operating the apparatus according to the first aspect of the present invention, the method comprising driving a current along the length of the magnetostrictive material layer and causing the strain imparting means to impart a strain pulse to the magnetostrictive material layer.

The method may comprise causing the strain imparting means to impart a compressive strain pulse to the magnetostrictive material layer. The method may comprise causing the strain imparting means to impart a tensile strain pulse to the magnetostrictive material layer.

Certain embodiments of the present invention will now be described, by way of example, with reference to the accompanying drawings, in which:

Figure 1a is schematic of magnetocrystalline anisotropy cases and for which perpendicular magnetocrystalline anisotropy, $K_p$, is kept constant;

Figure 1b is a schematic of a computational geometry;

Figure 2a is a graph showing plots of domain wall velocity, $v_{DW}$, as a function of the magnitude of current density, $|\vec{j}|$, for a subset of in-plane magnetocrystalline anisotropy, $K_{in}$, and non-adiabatic spin torque coefficient, β, values and with $K_p = 1.5$ kJ/m³;

Figure 2b is a graph showing plots of domain wall velocity, $v_{DW}$, as a function of a perpendicular applied magnetic field for different values of in-plane magnetocrystalline anisotropy, $K_{in}$ with $K_p = 1.5$kJ/m³;

Figure 2c is a graph showing plots of domain wall velocity, $v_{DW}$, as a function of a perpendicular applied magnetic field for different values of in-plane magnetocrystalline anisotropy, $K_{in}$ with $K_p = 1.5$kJ/m³;

Figure 3 is a graph showing plots of $j_c$ ($\beta = 2\alpha$), $j_w$($\beta = 2\alpha$) as a function of in-plane magnetocrystalline anisotropy, $K_{in}$ with $K_p = 1.5$kJ/m³;

Figure 4 is a schematic side view of a magnetic functional device;

Figure 5 is a schematic plan view of the magnetic functional device shown in Figure 4;

Figure 6 illustrates a logic device;

Figures 7a and 7b illustrate operation of the logic device shown in Figure 6.

Current and field-induced domain wall motion in a perpendicular material system having a tuneable magnetocrystalline in-plane anisotropy constant is micromagnetically simulated. It is shown that it is possible to significantly modulate Walker fields and critical current densities and thus the domain wall velocity. This has an advantage that tuning of the parameters can be done on the fly in one and the same device by an external parameter, such as stress.

A recent interest in magnetically perpendicular systems has emerged due to the relatively small current densities required to move a domain wall (DW) with a spin polarized current. However, also being able to tune the critical or Walker current density, $j_c$ or $j_n$, respectively and the Walker field, $H_W$, may be important in applications. Using materials whose anisotropies have a significant response to strain enables the said parameters to be modulated on the fly by piezoelectric stressor whose gate voltage can be continuously varied. Using micromagnetic simulations, a perpendicular stripe-system, with a variable in-plane magnetocrystalline anisotropy (MA) whose constant may be modulated is considered and has a general applicability to materials with significant magnetostriction. This is an alternative method to previous suggestions to tune the cross-sectional area such as that described by S-W Jung et al., Applied Physics Letters, volume 92, page 202508 (2008) or the quality factor by varying stripe thickness (requiring different samples for obtaining different $j_c$). The approach here enables continuous tuning of $j_{c,w}$ in one and the same device even during its operation.

Current-induced domain wall dynamics (CIDWD) is simulated by numerically solving the Gilbert equation with spin transfer torques (STTs):

$$\frac{\partial \vec{m}}{\partial t} = -\gamma \vec{m} \times \vec{H} + \alpha \vec{m} \times \frac{\partial \vec{m}}{\partial t} - (\vec{u}.\nabla)\vec{m} + \beta \vec{m} \times (\vec{u}.\nabla)\vec{m} \qquad (1)$$

where $\vec{m}$ is the unit magnetization vector, $H$ is the micromagnetic effective field (exchange+demagnetizing+MA+ applied+ Oersted field), γ is the gyromagnetic ratio ($2.21 \times 10^5$ m/As), α is the Gilbert damping, $\vec{u}$ is the spin current velocity given by $\vec{u}=(gP\mu_B/2eM_s)\vec{j}$ in which $P$ is spin polarization, $\vec{j}$ is the current density, $g$ is the Lande factor, $\mu_B$ is the Bohr magneton, e is the carrier charge and $M_s$ is the saturation magnetization. Finally, β denotes the non-adiabatic spin torque coefficient. For field-driven simulations, $\vec{u}$=0. We use our own code which has been published earlier for a study with $\vec{u}$=0, which is described in Roy et al, Physical Review B, volume 82, page 134411 (2010). For implementation, Equation 1 above is cast into Landau-Lifshitz-Gilbert (LLG) form. Details of the evaluation of $\vec{H}$ and the integration scheme can be found in Roy et al., Physical Review B, *ibid.*

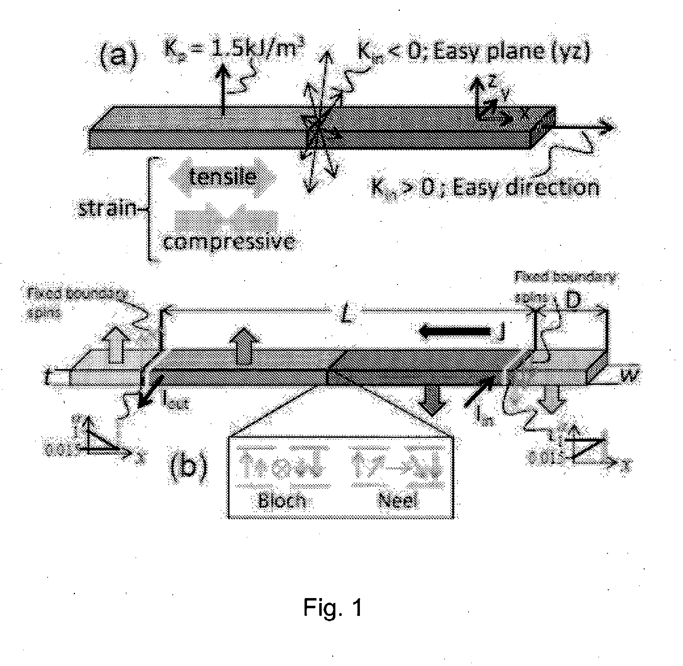

We chose a model system of a perpendicular diluted magnetic semiconductor, patterned as a stripe such as in D. Fang et. al., Nature Nanotechnology, doi:10.1038/nnano.2011.68 (2011) and K. Y. Wang et al., Applied Physics Letters, volume 97, 262102 (2010), namely $(Ga_{0.94}, Mn_{0.06})(As_{0.9}, P_{0.1})$, with a tuneable uniaxial MA along $x$, as shown in Figure 1(a). We chose this system as it has previously been experimentally shown that an in-plane anisotropy can be significantly modulated by strain in this material D. Fang et al., Nature Nanotechnology *ibis.*, but stress the point, that the principles shown here are valid for other systems that have tuneable anisotropies. Material parameters used here are chosen to approximate high working temperatures; $M_s$ = 18kA/m, $K_p$ (perpendicular MA constant) = 1.5kJ/m$^3$, $K_{in}$ (in-plane MA constant), varied as [-200,+200] J/m$^3$, $\alpha$ = 0.015, $g$ =2, $P$ =0.45 and the exchange stiffness, A =0.1 pJ/m.

The two MA energy densities are then: $e_u^x = -K_{in}\alpha_1^2$ and $e_u^z = -K_p\alpha_3^2$, where $\alpha_1$, $\alpha_3$ are the direction cosines along $x$ and $z$ with MA constants $K_{in}$ and $K_p$, respectively (see Figure 1(a)). Cubic anisotropy is neglected, assuming that it can be relatively small at high temperatures. $K_{in}$ is modulated by applying a homogeneous stress along $x$; a tensile strain decreases $K_{in}$ and can eventually lead to $K_{in}$ < 0, while a compressive strain increases $K_{in}$, keeping $K_{in}$ > 0. We have set $K_p$ as a constant value, i.e. assuming that the increase or decrease in $K_p$, $|\Delta K_p|$ << $K_p$, meaning that for compressive strain we are slightly underestimating the increase of the DW width and for tensile strain we are neglecting a small narrowing of the DW. This does not alter the qualitative behaviour we will demonstrate. A schematic of the computational region is shown in Figure 1(b) with L=512nm, w=128nm and t=25nm; Current is injected from right to left causing the DW moves to the right. A scheme that keeps the DW centred in the computational region was implemented, allowing for arbitrarily long DW displacements and physical times; in some instances, travel distances >10μm or physical simulation times > 1μs are used to capture the DW behaviour. At the ends, spin wave absorbers with linear variations in $\alpha$ were added. The discretization cell is $4\times4\times25$nm$^3$. At each side, saturated stripes with D=3μm were positioned, whose stray fields add to the total effective field in the computational region, simulating infinite extension along $x$.

Equilibrium DW states for different $K_{in}$ are calculated first. These are of either Bloch or Neel type (Figure 1(b)). The type is attributed to each $K_{in}$ based on the total energy. For the values of $K_{in}$ used here, the energy difference between Bloch and Neel states, $\Delta e_{B-N}$, is smallest for $K_{in}$ =50 J/m$^3$. $K_{in}$ < 0 results in an MA easy ($yz$) plane, while for $K_{in}$ > 0, a uniaxial MA along $x$ results. For $K_{in} \geq 50$, the equilibrium configuration is a Neel DW and $K_{in}$ <50 yield Bloch DWs. As $K_p$ is kept constant here, we find that as $K_{in}$ is increased for positive values, the DW width increases, but for $K_{in}$ < 0, the DW width does not change. Now, modulating $K_{in}$ changes the difference in energy density between the Bloch and Neel. states, $\Delta e_{B-N}$. Since $j_{c,w} \propto \Delta e_{B-N}$, it directly affects the CIDWD.

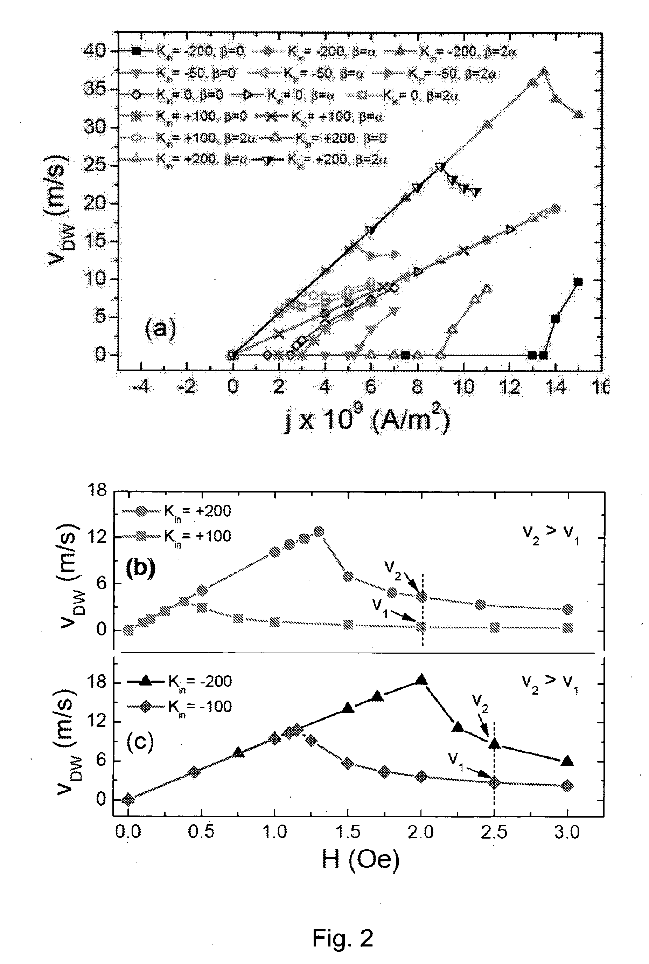

To validate the STT part of this code version, we initially checked the case of $K_{in}$ =0 for various $\beta$, computing the final DW velocity $(v_{DW})$ versus $\vec{J}$: For $\beta = \alpha$; $v_{DW} = u$ for all considered values of $\vec{J}$ (if $\beta = \alpha$, then $j_c \to \infty$), for $\beta = 2\alpha$ with $|\vec{J}| < j_w$; $v_{DW} = u.(\beta/\alpha)$ and for both $\beta = 2\alpha$ and $\beta = 0$ with $|\vec{J}| >> j_{c,w}$; $v_{DW} \to u.(1 + \alpha/\beta)/(1 + \alpha^2)$. Finally, we find that $j_c$ ($\beta = 0$) = $j_w$ ($\beta = 2\alpha$). This is all in accordance with predictions of the analytical 1D model and observations in other numerical work. We find that these observations hold irrespective of the value of $K_{in}$ as shown in Figure 2(a), for a subset of the considered $K_{in}$ values. Thus, we shall assume that calculating $j_c$ for any value of $K_{in}$ for $\beta = 0$, will automatically give $j_w$ for $\beta = 2\alpha$.

The first conclusion from Figure 2(a), is that in the steady regime, $v_{DW}$ is independent of $K_{in}$. Secondly, for $\beta = \alpha$, $v_{DW}$ is always independent of $K_{in}$. Thirdly, what is being changed is $j_{c,w}$ for $\beta \neq \alpha$. Thus, if there is a strain dependence of $j_{c,w}$ and/or $v_{DW}$, then $\beta \neq \alpha$ is a likely scenario. Further, using a material with a strain dependence on its MA constants enables using only one sample, as opposed to the case considered, for example in S-W Jung, Applied Physics Letters *ibis*., whereby many specimens are required, thus risking a spread in sample characteristics. Therefore, knowing the strain dependence of the MA-constants of a single stripe sample and then measuring CIDWD, should allow for a safer fitting to micromagnetic simulations. Corresponding cases for the field driven case, with a field along +$z$ were also simulated, as shown in Figures 2(b) and 2(c). $H_w$ is naturally modulated as $\Delta e_{B-N}$ is altered by $K_{in}$. From an experimental point of view, the measurements of $v_{DW}$ in the field driven case can appear to behave oppositely to that of the CIDWD (depending on $\beta$) and the regime in which we measure within; As an example, consider two strain-cases with a $K_{in,1}$ and $K_{in,2}$, where $|K_{in,1}| < |K_{in,2}|(\Delta e_{B-N}, \neq 0)$ with DW velocities $v_{DW,1}$ and. $v_{DW,2}$, respectively and $\beta$=0. Now, assume that we are at a $j > j_c$ for both cases but not so large as to approach its asymptotic limit. Then, $v_{DW,1} > v_{DW,2}$, due to the relative shift in $j_c$. This should be the case for $\beta < \alpha$. In the field driven case, then $v_{DW,2} > v_{DW,1}$ (Figures 2(b) and 2(c)) at a given applied field larger than $H_w$. Now, for $\beta > \alpha$, here tested for $\beta = 2\alpha$, then $v_{DW,2} > v_{DW,1}$ and would have the same velocity trend as the field driven case.

These characteristics may be helpful as a validation experiment in determining if $\beta$ is smaller or larger than $\alpha$. It is to be noted, that we have here not considered the effects of defect-related pinning.

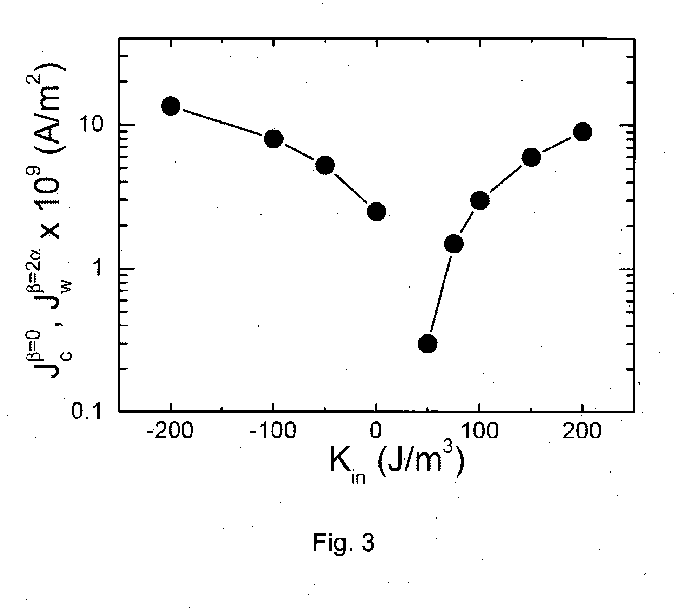

The results reported here also has interesting implications for applications. By changing the strain on the fly during device operation for any given current density, one may induce or prohibit a Walker breakdown, thus altering $v_{DW}$ significantly. In such a way, speed-up or slow-down of the DWs during travel may be achieved. A summary of $j_c(\beta = 0)$ = $j_w$ ($\beta = 2\alpha$) as a function of $K_{in}$ is shown in Figure 3, demonstrating the range of control that we can achieve on the CIDWD in one and the same stripe by modulating $K_{in}$.

Finally, a stabilization of the Bloch state and thus an increase of $j_{c,w}$ by the Rashba spin-orbit (SO)-field in Pt/Co stripes was reported by Miron *et al.*, Nature Materials, volume 10, page 419 (2011). This acts as a Zeeman term, in a uni-directional preferred orientation. Rashba and Dresselhaus terms vary linearly with current, (no results of the strain dependence has been reported so far for the material considered here). In our geometry, the sum of these would be

oriented along y in Figure 1(b) and can contribute to $De_{B-N}$. A test with the SO-fields for $K_{in} = 0$ with $\beta = 2\alpha$ was performed using values in D. Fang et al., Nature nanotechnology, *ibid.* (although for T=6 K), showing an increase of $j_w$ from 2.5 to $3 \times 10^9$ A/m$^2$. Their significance will depend on the size and relative directions of the MA-fields as well. Contributions by the SO-fields are left for forthcoming work.

The results presented herein offer an alternative route than previous suggestions. This is useful in device applications, whereby modulation of the said parameters may be necessary in one and the same stripe during its operation.

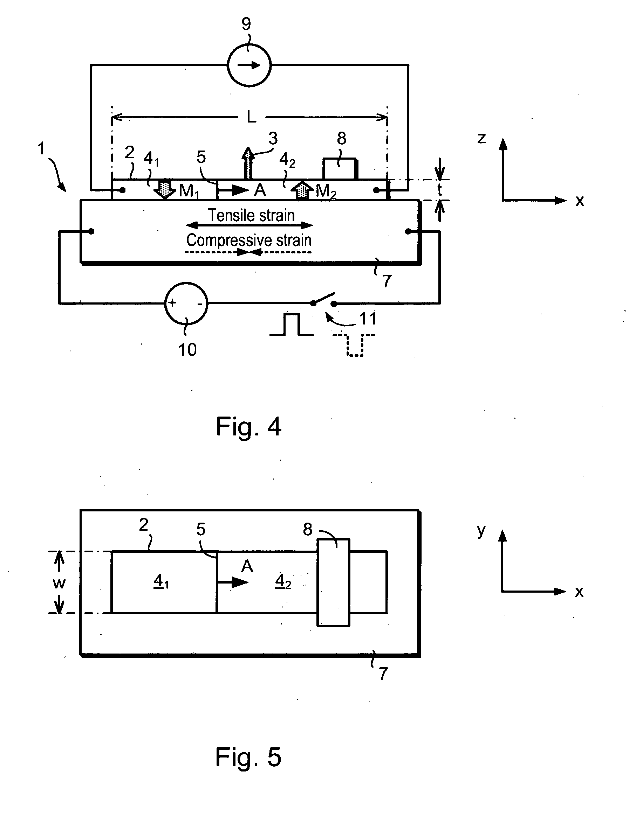

Referring to Figures 4 and 5, a device 1 in accordance with the present invention is shown. In this example, the device 1 is an information storage device (herein also referred to as a "memory device").

The device 1 comprises a layer 2 of magnetostrictive material. In Figures 4 and 5, the layer is shown lying in the x-y plane. The layer 2 is configured such that magnetic anisotropy 3 is perpendicular to the layer 1. This may be achieved, for example, by making the layer sufficiently thin or by using a magnetostrictive material that has inherently a perpendicular magnetocrystalline anisotropy. The magnetostrictive layer 2 is preferably elongate.

The magnetostrictive layer 2 includes two or more domains $4_1$, $4_2$ divided by at least one domain wall $5_1$. In this example, there are only two domains $4_1$, $4_2$ and one domain wall $5_1$ and the domains $4_1$, $4_2$ have magnetizations $M_1$ and $M_2$ aligned parallel or anti-parallel to the direction of magnetic anisotropy 3.

The magnetostrictive layer 2 has a length, L and a thickness, t. The domain wall has a non-zero length (not shown). The length, L, of the magnetostrictive layer 2 exceeds the length of the domain wall which may has a length of about 20 to 70 nm. The magnetostrictive layer 2 can have a length, L, of at least 1 $\mu$m, at least 10 $\mu$m or at least 100 $\mu$m. The device may have a width, w, of at least 40 nm, at least 100 nm or at least 500 nm. The device may have a width, w, no more than 1 $\mu$m or no more than 5 $\mu$m.

The layer 2 is arranged so as to sustain a domain wall 5 having a relatively uniform profile from the bottom to the top of the layer 2 and to allow the domain wall 5 to propagate smoothly in the layer 2, for example without substantial twisting along the z-direction as the domain wall 5 propagates along the x-axis. A suitable thickness, t, of the layer 2 can be found by routine experiment. However, the thickness, t, typically tends to be no more than about three times the magnetic exchange length, $\delta$. The thickness, t, can be less than or equal to about 30 nm or less than or equal to about 5 nm, and can be small as 1.5 nm or less.

The magnetostrictive material may comprise $(Ga_{0.94}, Mn_{0.06})(As_{0.9}, P_{0.1})$. However, other magnetostrictive material can be used such as alloys of a ferromagnetic element, such as cobalt, iron and/or nickel, and a transition metal, such as platinum and palladium. Candidate materials are described in US 6 483 741 B *ibis.* The magnetostrictive material preferably has a high Curie temperature, i.e. well above room temperature.

The device 1 includes a structure (not shown) for precipitating domain wall nucleation. The structure may take the form of an implanted region in the magnetostrictive layer 2, a stressor for imparting strain to a localised region of the magnetostrictive layer 2 or a notch etched into the surface of the magnetostrictive layer 2.

The device 1 also comprises a stressor 7 for imparting in-plane strain to the magnetostrictive layer 2. In this example, the stressor takes the form of an actuator comprising a piezoelectric layer 7 arid a suitable actuator is available from Piezomechanik Dr. Lutz Pickelmann GmbH, Munich, Germany. The stressor 7 preferably induces a strain in the magnetostrictive layer 2 of an order of magnitude of $10^{-4}$ or $10^{-3}$.

The magnetostrictive layer 2 may be formed directly on the stressor 7, for example, by depositing a metal alloy. However, the magnetostrictive layer 2 may be supported by a substrate for example, a semiconductor substrate on which a semiconductor layer is grown and which may have been thinned. The magnetostrictive layer 2 or supporting substrate (not shown) may be glued to the stressor 7. The stressor 7 is arranged so that it can apply a stress pulse for a duration, $t_1$. The stressor 7 is arranged such that it can apply compressive stress or tensile stress along the magnetostrictive layer 2.

As shown in Figures 4 and 5, a magnetic field sensor 8 may be configured to sense the magnetic field at a point or in a portion of the magnetostrictive layer 2. The sensor 7 may take the form of a TMR sensor, a Hall effect device or a wire in which current is induced. The sensor 8 may be mounted on the surface of the layer 2. In some embodiments, one or more lateral contacts can be used to measure a transverse voltage across the layer 2 (i.e. along the y-direction).

A current source 9 is used to drive a current through the magnetostrictive layer 2 and, thus, cause the domain wall to move (for example, as shown by the arrow A). As explained earlier, the velocity, $v_{DW}$, of the domain wall 5 can be changed by applying in-plane stress to the magnetostrictive layer 2. This can be achieved by applying a voltage pulse across a piezoelectric layer 7 using a voltage source 10 and switch 11. The voltage pulse may have a duration, $t_2$. The stress pulse may start before the current pulse and end after the current pulse and, thus, $t_2 > t_1$. However, this need not be the case and the voltage pulse may start or change polarity while the current pulse is being applied.

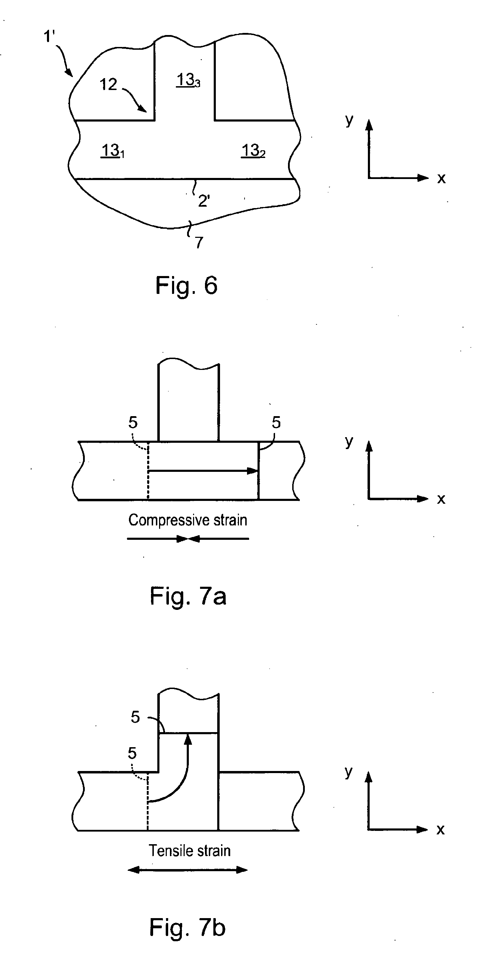

Referring to Figure 6, another device 1' in accordance with the present invention is shown. In this example, the device 1' is a logic device.

The device 1' is similar to the device 1 described earlier with reference to Figures 4 and 5. However, the device 1' has a magnetostrictive layer 2' which includes one or more nodes 12 having a first, second and third branches $13_1$, $13_2$, $13_3$.

Referring to Figure 7a, a propagating domain wall 5 can be encouraged to pass from the first branch $13_1$ into the second branch $13_2$ by, for example, applying a stress pulse so as to cause compressive strain along the direction of the first branch $13_1$ and/or the second branch $13_2$. In this example, compressive strain along the x-axis generally makes the domain wall 5 move along x-axis. Such a stress pulse might represent, for example, a logical '0'.

Referring to Figure 7b, a propagating domain wall 5 can be encouraged to pass from the first branch $13_1$ into the third branch $13_3$ by, for example, applying a stress pulse so as to cause tensile strain along the direction of the first branch $13_1$ and the second branch $13_2$, thus causing a compressive strain along the third branch $13_3$ (y-direction). In this example, tensile strain along x-axis generally compresses the layer along the y-axis and so that the domain wall 5 moves along the y-axis. Such a stress pulse might represent, for example, a logical '1'.

The output of the node 13 can be sensed using magnetic field sensor 8 placed on one or both branches $13_2$, $13_3$.

It will be appreciated that stress can be applied to more than one node at the same time and, thus, can be used to provide global control.

It will be appreciated that many modifications may be made to the embodiments hereinbefore described.

For example, the magnetostrictive layer 2 may be folded so as to have two (or more) long portions running substantially parallel to each other joined by short portions which are perpendicular to the long portions so as to form a racetrack similar to that described in US 2004 251232 A and in "Magnetic Domain-Wall Racetrack Memory" by Stuart S. P Parkin, Masamitsu Hayashi and Luc Thomas, Science, volume 320, pages 190 to 194 (2008).

More than one stressor can be used and may be arranged to provide stress in different (e.g. orthogonal) directions.

The functional devices may be arranged in an array and which are individually addressable.

## Claims

1. Apparatus comprising:

   a magnetic functional device comprising:

   a layer (2) of magnetostrictive material configured such that magnetic anisotropy is perpendicular to the layer, wherein the layer (2) has a length (L) and includes first and second domains (41, 42) divided, along the length, by a domain wall (51); and
   means (7, 10) for imparting in-plane strain to the magnetostrictive material layer; and

   a source (9) configured to drive a current along the length of the magnetostrictive material layer so as to cause the domain wall to move along the length of the layer.

2. Apparatus according to claim 1, wherein the strain-imparting means (7) comprises a stressor.

3. Apparatus according to claim 1 or 2, wherein the strain-imparting means (7) comprises a piezoelectric element.

4. Apparatus according to any preceding claim, wherein the layer (2) has a thickness no more than about three times the exchange length of the magnetostrictive material.

5. Apparatus according to any preceding claim, wherein the layer (2) has a thickness less than 25 nm, optionally less than 10 nm and/or optionally less than 5 nm.

6. Apparatus according to any preceding claim, wherein the length of the layer (2) is at least 200 nm, optionally is at least 500 nm and/or optionally is at least 1 $\mu$m.

7. Apparatus according to any preceding claim, wherein the layer (2) forms a track having a width, the track having a width of at least 40 nm.

8. Apparatus according to any preceding claim, wherein the layer (2) forms a track having a width, the track has a width no more than 5 $\mu$m.

9. Apparatus according to any preceding claim, wherein the magnetostrictive material comprises a ferromagnetic element.

10. Apparatus according to any preceding claim, the magnetostrictive material comprises a non-ferromagnetic transition element.

11. Apparatus according to any preceding claim, wherein the magnetic functional device is a magnetic memory device.

12. Apparatus according to any preceding claim wherein the magnetic functional device is a magnetic logic device.

13. A method of operating apparatus according to any one of claims 1 to 12, the method comprising:

     driving a current along the length of the magnetostrictive material layer; and
     causing the strain imparting means to impart a strain pulse to the magnetostrictive material layer.

14. A method according to claim 13, comprising:

     causing the strain imparting means to impart a compressive strain pulse to the magnetostrictive material layer.


**Patentansprüche**

1. Vorrichtung, umfassend:

     ein magnetisches Funktionsteil, umfassend:

          eine Schicht (2) magnetostriktives Material, die so konfiguriert ist, dass die magnetische Anisotropie lotrecht zu der Schicht ist, wobei die Schicht (2) eine Länge (L) hat und eine erste und eine zweite Domäne ($4_1$, $4_2$) beinhaltet, die entlang der Länge durch eine Domänenwand ($5_1$) getrennt sind, und
          ein Mittel (7, 10) zum Mitteilen einer In-Plane-Spannung an die magnetostriktive Materialschicht; und

     eine Quelle (9), die zum Treiben eines Stroms entlang der Länge der magnetostriktiven Materialschicht konfiguriert ist, um zu veranlassen, dass sich die Domänenwand entlang der Länge der Schicht bewegt.

2. Vorrichtung nach Anspruch 1, wobei das spannungsmitteilende Mittel (7) einen Stressor aufweist.

3. Vorrichtung nach Anspruch 1 oder 2, wobei das spannungsmitteilende Mittel (7) ein piezoelektrisches Element aufweist.

4. Vorrichtung nach einem der vorhergehenden Ansprüche, wobei die Schicht (2) eine Dicke von höchstens etwa dem Dreifachen der Austauschlänge des magnetostriktiven Materials hat.

5. Vorrichtung nach einem der vorhergehenden Ansprüche, wobei die Schicht (2) eine Dicke von weniger als 25 nm, wahlweise weniger als 10 nm und/oder wahlweise weniger als 5 nm hat.

6. Vorrichtung nach einem der vorhergehenden Ansprüche, wobei die Länge der Schicht (2) wenigstens 200 nm ist, wahlweise wenigstens 500 nm ist und/oder wahlweise wenigstens 1 $\mu$m ist.

7. Vorrichtung nach einem der vorhergehenden Ansprüche, wobei die Schicht (2) eine Bahn mit einer Breite bildet, wobei die Bahn eine Breite von wenigstens 40 nm hat.

8. Vorrichtung nach einem der vorhergehenden Ansprüche, wobei die Schicht (2) eine Bahn mit einer Breite bildet, wobei die Bahn eine Breite von höchstens 5 $\mu$m hat.

9. Vorrichtung nach einem der vorhergehenden Ansprüche, wobei das magnetostriktive Material ein ferromagnetisches Element aufweist.

10. Vorrichtung nach einem der vorhergehenden Ansprüche, wobei das magnetostriktive Material ein nicht ferromagnetisches Übergangselement aufweist.

11. Vorrichtung nach einem der vorhergehenden Ansprüche, wobei das magnetische Funktionsteil eine magnetische Speichereinrichtung ist.

12. Vorrichtung nach einem der vorhergehenden Ansprüche, wobei das magnetische Funktionsteil ein magnetischer Logikbaustein ist.

13. Verfahren zum Betreiben einer Vorrichtung nach einem der Ansprüche 1 bis 12, wobei das Verfahren Folgendes aufweist:

Treiben eines Stroms entlang der Länge der magnetostriktiven Materialschicht und
Veranlassen des spannungsmitteilenden Mittels zum Mitteilen eines Spannungsimpulses an die magnetostriktive Materialschicht.

14. Verfahren nach Anspruch 13, das Folgendes aufweist:

Veranlassen des spannungsmitteilenden Mittels zum Mitteilen eines Druckspannungsimpulses an die magnetostriktive Materialschicht.

**Revendications**

1. Appareil comportant :

un dispositif fonctionnel magnétique comportant :

une couche (2) de matériau magnétostrictif configurée de telle sorte qu'une anisotropie magnétique est perpendiculaire par rapport à la couche, dans lequel la couche (2) a une longueur (L) et comprend des premier et deuxième domaines ($4_1$, $4_2$) divisés, sur la longueur, par une paroi de domaine ($5_1$) ; et
un moyen (7, 10) servant à transmettre une contrainte dans le plan à la couche de matériau magnétostrictif ; et

une source (9) configurée à des fins d'entraînement d'un courant sur la longueur de la couche de matériau magnétostrictif de manière à amener la paroi de domaine à se déplacer sur la longueur de la couche.

2. Appareil selon la revendication 1, dans lequel le moyen de transmission de contrainte (7) comporte un élément d'effort.

3. Appareil selon la revendication 1 ou la revendication 2, dans lequel le moyen de transmission de contrainte (7) comporte un élément piézoélectrique.

4. Appareil selon l'une quelconque des revendications précédentes, dans lequel la couche (2) a une épaisseur ne mesurant pas plus d'environ trois fois la longueur d'échange du matériau magnétostrictif.

5. Appareil selon l'une quelconque des revendications précédentes, dans lequel la couche (2) a une épaisseur mesurant moins de 25 nm, éventuellement moins de 10 nm et/ou éventuellement moins de 5 nm.

6. Appareil selon l'une quelconque des revendications précédentes, dans lequel la longueur de la couche (2) mesure au moins 200 nm, éventuellement mesure au moins 500 nm et/ou éventuellement mesure au moins 1 $\mu$m.

7. Appareil selon l'une quelconque des revendications précédentes, dans lequel la couche (2) forme une piste ayant une largeur, la piste ayant une largeur mesurant au moins 40 nm.

8. Appareil selon l'une quelconque des revendications précédentes, dans lequel la couche (2) forme une piste ayant une largeur, la piste a une largeur ne mesurant pas plus de 5 $\mu$m.

9. Appareil selon l'une quelconque des revendications précédentes, dans lequel le matériau magnétostrictif comporte un élément ferromagnétique.

10. Appareil selon l'une quelconque des revendications précédentes, le matériau magnétostrictif comportant un élément de transition non ferromagnétique.

**11.** Appareil selon l'une quelconque des revendications précédentes, dans lequel le dispositif fonctionnel magnétique est un dispositif à mémoire magnétique.

**12.** Appareil selon l'une quelconque des revendications précédentes, dans lequel le dispositif fonctionnel magnétique est un dispositif à logique magnétique.

**13.** Procédé de fonctionnement de l'appareil selon l'une quelconque des revendications 1 à 12, le procédé comportant :

l'étape consistant à entraîner un courant sur la longueur de la couche de matériau magnétostrictif ; et
l'étape consistant à amener le moyen de transmission de contrainte à transmettre une impulsion de contrainte à la couche de matériau magnétostrictif.

**14.** Procédé selon la revendication 13, comportant :

l'étape consistant à amener le moyen de transmission de contrainte à transmettre une impulsion de contrainte de compression à la couche de matériau magnétostrictif.

Fig. 1

Fig. 2

Fig. 3

Fig. 4

Fig. 5

Fig. 6

Compressive strain

Fig. 7a

Tensile strain

Fig. 7b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20100032738 A1
- US 6483741 B
- US 6387476 B
- US 2004251232 A

### Non-patent literature cited in the description

- **K. Y. WANG et al.** domain wall resistance in perpendicular (Ga,Mn)As: Dependence on pining. *Journal of Magnetism and Magnetic Materials,* 2010, vol. 322, 3481-3484
- **S-W JUNG et al.** *Applied Physics Letters,* 2008, vol. 92, 202508
- **ROY et al.** *Physical Review B,* 2010, vol. 82, 134411
- **ROY et al.** *Physical Review B*
- **D. FANG.** *Nature Nanotechnology,* 2011
- **K. Y. WANG et al.** *Applied Physics Letters,* 2010, vol. 97, 262102
- **D. FANG et al.** *Nature Nanotechnology*
- **D. FANG et al.** *Nature nanotechnology*
- **STUART S. P PARKIN ; MASAMITSU HAYASHI ; LUC THOMAS.** Magnetic Domain-Wall Racetrack Memory. *Science,* 2008, vol. 320, 190-194